# EUROPEAN PATENT APPLICATION

(11) **EP 4 676 163 A1**
(43) Date of publication of application: **07.01.2026**
(21) Application number: 25166088.2
(22) Date of filing: 25.03.2025
(51) Int. Cl.: H05B 6/12, F24C 7/10

(54) **BATTERY INDUCTION WARMER**

(30) Priority: 02.07.2024 US 202418761328
(71) Applicant: SEF Tech Co., Ltd., 114065 Taipei City (TW)
(72) Inventor: LO, HAN-CHING, TAIPEI CITY (TW); LIU, LUN-SHAN, TAIPEI CITY (TW)
(74) Representative: Durán-Corretjer, S.L.P.

(57) **Abstract**

A battery induction warmer (100) includes a housing body (1), a heating module (2), at least one battery (3), and a control module (4). The housing body (1) has an accommodation space (A11), and a top opening (A12) and a mounting hole (A13) that are in spatial communication with the accommodation space (A11). The heating module (2) is disposed on the housing body (1). The top opening (A12) is covered by the heating module (2). The at least one battery (3) is detachably disposed in the housing body (1) by passing through the mounting hole (A13). The at least one battery (3) is located in the accommodation space (A11), and a portion of the at least one battery (3) is exposed from an outer side of the housing body (1) by the mounting hole (A13). The control module (4) is disposed in the accommodation space (A11), and is configured to control the heating module (2) to perform heating via power from the at least one battery (3).

## Description

### FIELD OF THE INVENTION

The present invention relates to an induction warmer, and more particularly to a battery induction warmer.

### BACKGROUND OF THE INVENTION

A conventional induction warmer can generate sufficient heat for cooking food using mains electricity. However, due to the reliance on mains electricity as the only energy source of the conventional induction warmer, the conventional induction warmer is not portable (e.g., the conventional induction warmer cannot be used for camping in remote locations without access to mains electricity).

### SUMMARY OF THE INVENTION

In response to the above-referenced technical inadequacy, the present invention provides a battery induction warmer.

In order to solve the above-mentioned problems, one of the technical aspects adopted by the present invention is to provide a battery induction warmer. The battery induction warmer includes a housing body, a heating module, at least one battery, and a control module. The housing body has an accommodation space, and a top opening and a mounting hole that are in spatial communication with the accommodation space. The heating module is disposed on the housing body. The top opening is covered by the heating module, and a portion of the heating module is located in the accommodation space. The at least one battery is detachably disposed in the housing body by passing through the mounting hole. The at least one battery is located in the accommodation space, and a portion of the at least one battery is exposed from an outer side of the housing body by the mounting hole. The control module is disposed in the accommodation space and is electrically coupled to the heating module and the at least one battery. The control module is configured to control the heating module to perform heating via power from the at least one battery.

In one of the possible or preferred embodiments, the housing body has a bottom plate that is opposite to the top opening, and a plurality of side plates that are connected to the bottom plate. The mounting hole is located on one of the side plates.

In one of the possible or preferred embodiments, a surface of the portion of the at least one battery exposed from the outer side of the housing body and the one of the side plates having the mounting hole are coplanar.

In one of the possible or preferred embodiments, the housing body further includes a plurality of retaining walls parallel to the side plates, and the retaining walls are configured to abut against the at least one battery. A height of each of the retaining walls is less than a height of the at least one battery, so that the retaining walls and the heating module jointly have a heat dissipation gap there-between.

In one of the possible or preferred embodiments, the battery induction warmer further includes a plurality of cooling fins disposed in the accommodation space. The housing body has two vent regions that are in spatial communication with the accommodation space, and one of the two vent regions is disposed on one of the side plates away from the at least one battery. The at least one battery, the cooling fins, the heat dissipation gap, and the one of the two vent regions are jointly passed by an imaginary configuration line.

In one of the possible or preferred embodiments, the battery induction warmer further includes a fan disposed in the accommodation space. The cooling fins are parallel to each other and perpendicular to the imaginary configuration line. The fan has an airflow path, and the airflow path is configured to pass through the cooling fins and exit from another one of the two vent regions disposed on the bottom plate by the side plates.

In one of the possible or preferred embodiments, the battery induction warmer further includes a limiting structure disposed on the housing body. The at least one battery has a recessed groove. A portion of the limiting structure is exposed from the outer side of the housing body, and the portion of the limiting structure is capable of being operated, such that the limiting structure is movable between a release position and a restriction position. When the limiting structure is located in the restriction position, the limiting structure abuts against the recessed groove of the at least one battery and restricts the at least one battery from movement. When the limiting structure is located in the release position, the limiting structure is moved away from the recessed groove of the at least one battery, and the at least one battery is detachable from the housing body.

In one of the possible or preferred embodiments, the at least one battery includes an output port, and the control module includes an input port. When the at least one battery is restricted from movement by the limiting structure located in the restriction position, the output port is electrically coupled to the input port, such that power from the at least one battery is input to the control module. When the at least one battery is detached from the housing body, the output port is away from the input port and is not electrically coupled to the input port.

In one of the possible or preferred embodiments, the limiting structure includes an installation bracket, an operating element, and a hook element. The installation bracket is fixed on the housing body and is located in the accommodation space. The operating element is disposed on the installation bracket, and the operating element includes a button, two drive arms, and a first spring. The button is located on one of two sides of the installation bracket. The two drive arms are connected to the button. A portion of each of the two drive arms spans across the installation bracket and is located on another one of the two sides of the installation bracket. The portion of each of the two drive arms has a bump. The first spring is disposed between a surface of the installation bracket and a surface of the button that face each other. The first spring is configured to abut against the button and the installation bracket, so that the button and the two drive arms move in a direction away from a center of the housing body. The hook element is located on the another one of the two sides of the installation bracket, and the hook element includes a hook block and a second spring. The hook block has an accommodating groove and two tracks. Each of the two tracks is in spatial communication with the accommodating groove and is skewed relative to the longitudinal direction of the first spring. Two bumps of the two drive arms are respectively assembled in the two tracks, so that the hook block is movable relative to the operating element. The second spring is disposed in the accommodating groove and is perpendicular to the longitudinal direction of the first spring. The second spring is configured to abut against the hook block and the surface of the heating module. The limiting structure is configured to remain at the restriction position by the first spring and the second spring. When the limiting structure is located in the restriction position, a portion of the button is exposed from the outer side of the housing body, and the hook block is pulled by the two drive arms, so that the hook block abuts against the recessed groove. When the limiting structure is located in the release position, the portion of the button moves towards the housing body, and the hook block is pushed by the two drive arms, so that the hook block is detached from the recessed groove.

In one of the possible or preferred embodiments, a quantity of the at least one battery is 2, and the control module is configured to detect charge levels of the two batteries and select one of the two batteries having a higher charge level to power the heating module.

Therefore, in the battery induction warmer provided by the present invention, by virtue of "the at least one battery being detachably disposed in the housing body by passing through the mounting hole," and "the control module being configured to control the heating module to perform heating via power from the at least one battery," the battery induction warmer can be used in any area and can quickly maintain the operation of the battery induction warmer by replacing the at least one battery.

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a schematic perspective view of a battery induction warmer according to the present invention;
FIG. 2 is a schematic exploded view of the battery induction warmer according to the present invention;
FIG. 3 is a schematic cross-sectional view taken along line III-III of FIG. 1;
FIG. 4 is a schematic cross-sectional view taken along line IV-IV of FIG. 1;
FIG. 5 is a schematic enlarged view of section V of FIG. 4;
FIG. 6 is a schematic enlarged view showing a limiting structure located in a release position according to the present invention;
FIG. 7 is a schematic exploded view of the limiting structure according to the present invention;
FIG. 8 is another schematic exploded view of the limiting structure according to the present invention;
FIG. 9 is a schematic cross-sectional view taken along line IX-IX of FIG. 1; and
FIG. 10 is a schematic perspective view of the battery induction warmer in another implementation according to the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

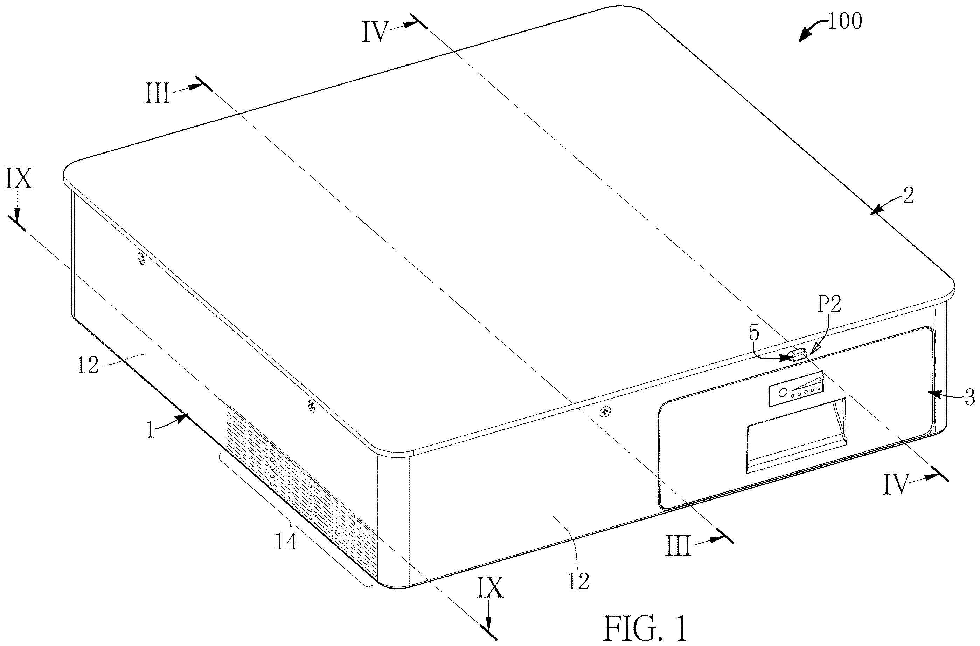

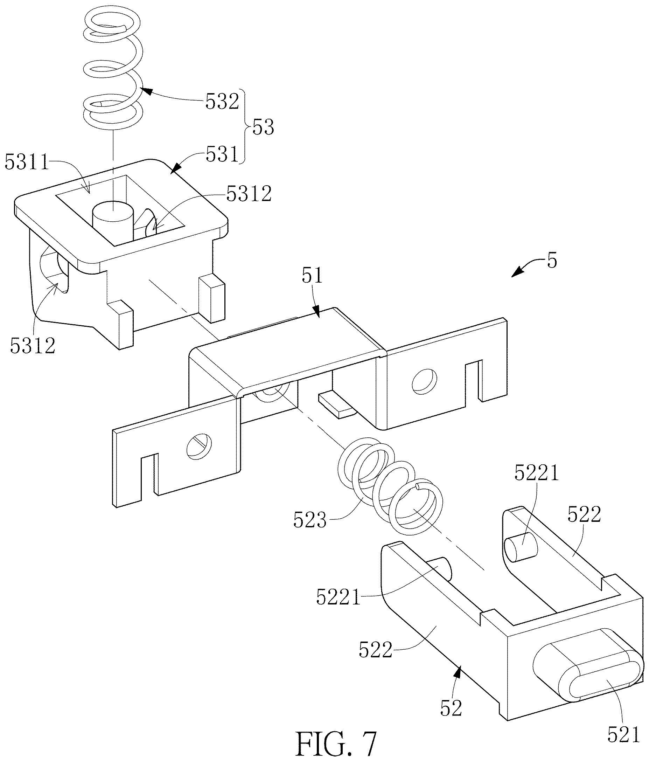

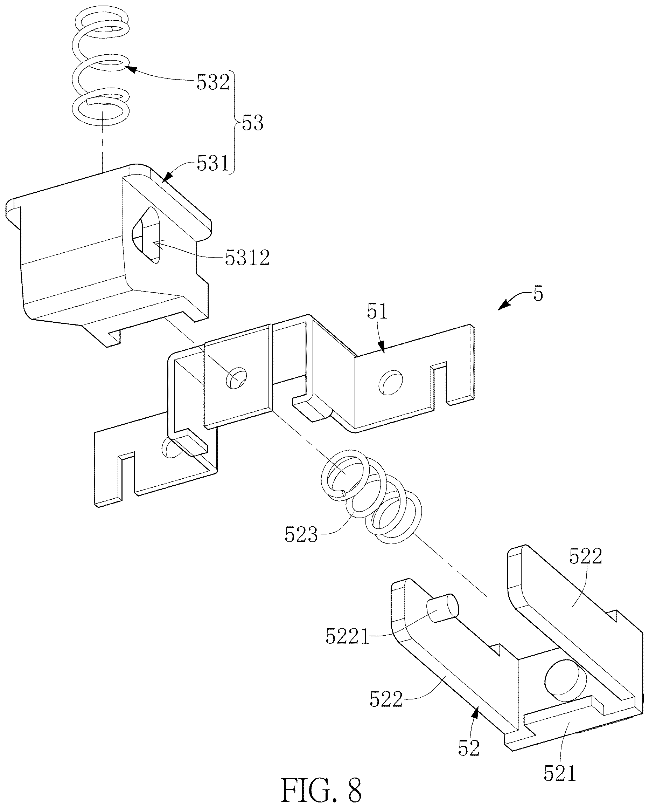

Referring to FIG. 1 to FIG. 10, the present invention provides a battery induction warmer 100. The battery induction warmer 100 includes a housing body 1, a heating module 2 disposed on the housing body 1, at least one battery 3 detachably disposed in the housing body 1, and a control module 4 that is electrically coupled to the heating module 2 and the at least one battery 3. The battery induction warmer 100 can use the control module 4 to provide power from the at least one battery 3 to the heating module 2 for heating, thereby allowing the battery induction warmer 100 to operate without being limited by the usage environment. The following description describes the structure and connection relation of each of the components of the battery induction warmer 100.

Referring to FIG. 1, FIG. 2, and FIG. 9, the housing body 1 in the present embodiment is a square concave structure, and has an accommodation space A11, and a top opening A12 and a mounting hole A13 that are in spatial communication with the accommodation space A11.

In detail, the housing body 1 has a bottom plate 11 that is opposite to the top opening A12, and a plurality of side plates 12 that are connected to the bottom plate 11. In other words, the bottom plate 11 and the side plates 12 together form the accommodation space A11, and the top opening A12 is on a side of the housing body 1 away from the bottom plate 11. Moreover, the mounting hole A13 is located on one of the side plates 12 that is used as an entry point for installing the at least one battery 3.

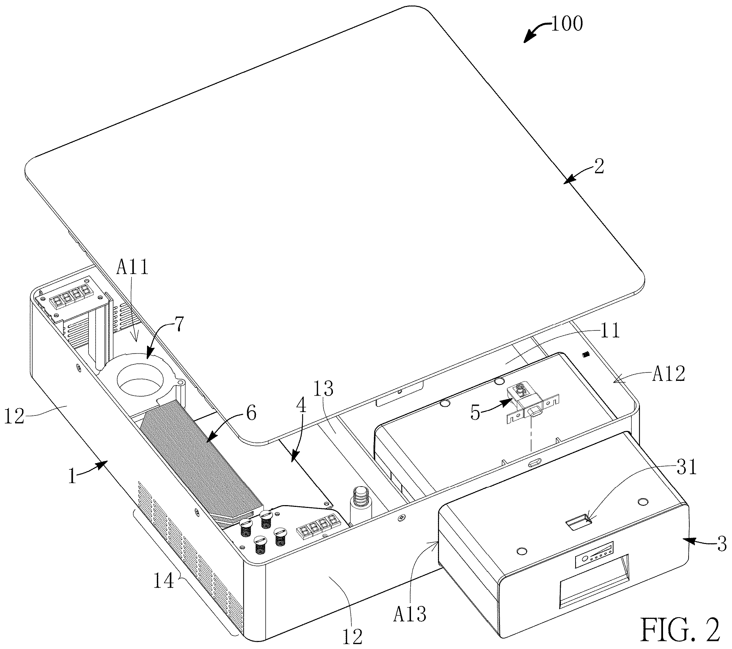

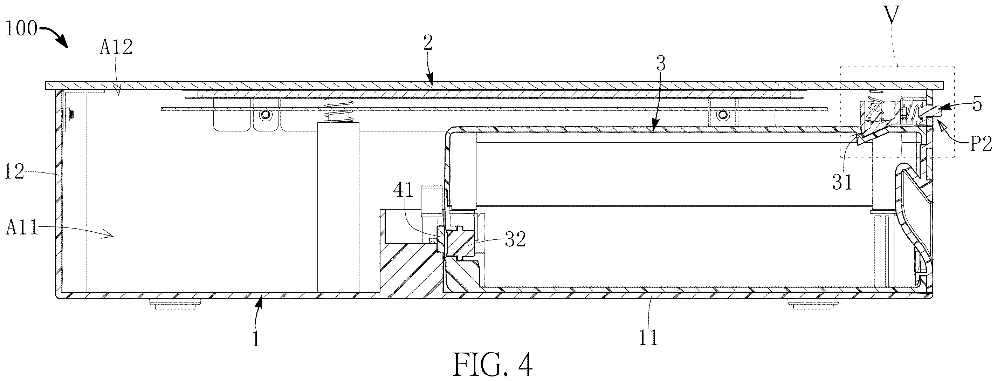

Referring to FIG. 2 and FIG. 4, the heating module 2 is disposed on the housing body 1, the top opening A12 is covered by the heating module 2, and one portion of the heating module 2 is located in the accommodation space A11. In other words, another one portion of the heating module 2 is located on an outer side of the housing body 1 and serves as a contact plate (e.g., a glass plate) that can directly contact cooking utensils. Moreover, the inductance value of the heating module 2 preferably is within a range from 10uH to 20uH.

Referring to FIG. 2 to FIG. 4, the at least one battery 3 is detachably disposed in the housing body 1 by passing through the mounting hole A13, and the at least one battery 3 is located in the accommodation space A11. Moreover, a portion of the at least one battery 3 is exposed from an outer side of the housing body 1 by the mounting hole A13 and can further have a recessed region for fingers to hook, such that users can easily detach the at least one battery 3 from the outer side of the housing body 1.

Preferably, a surface of the portion of the at least one battery 3 exposed from the outer side of the housing body 1 and the one of the side plates 12 having the mounting hole A13 are coplanar (as shown in FIG. 1). In another embodiment of the present invention (not shown), in order to facilitate the removal of the at least one battery 3 from the housing body 1, the battery induction warmer 100 includes an elastic operating element 52 (e.g., a push-to-open latch) that is installed in the housing body 1 and can selectively push the at least one battery 3 away from the housing body 1.

However, the present invention is not limited to the at least one battery 3 and the one of the side plates 12 being coplanar. For example, the at least one battery 3 can protrude from the one of the side plates 12.

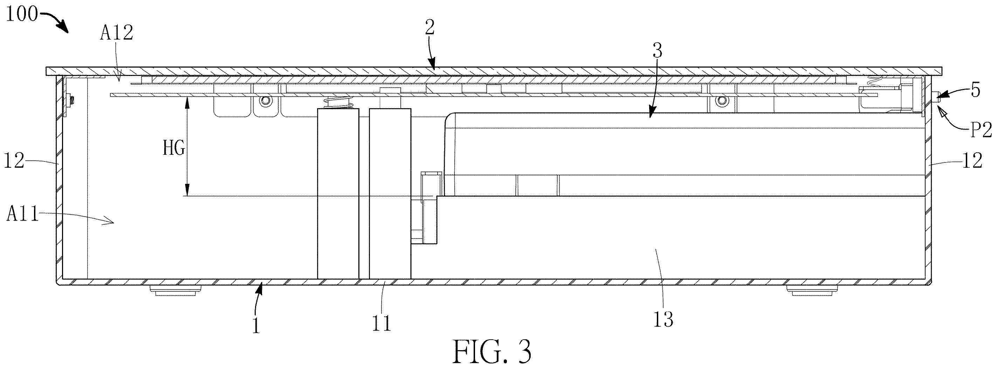

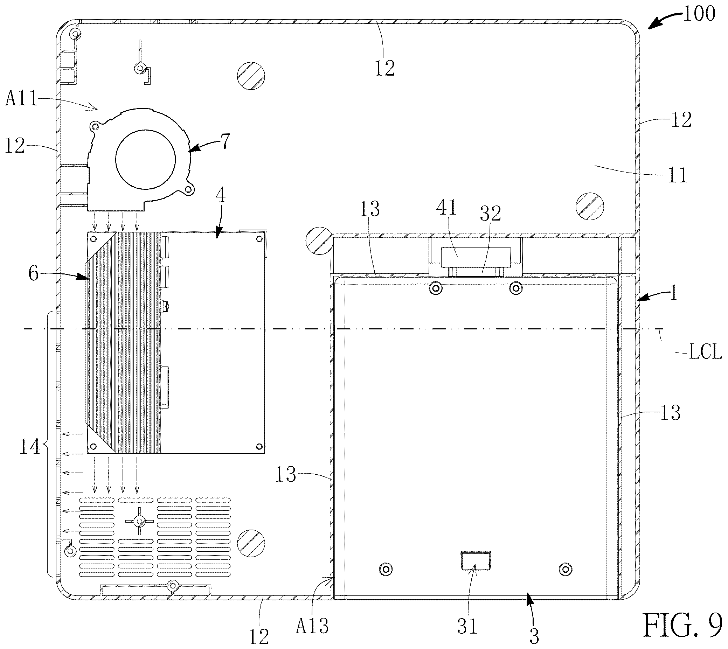

Moreover, in order to ensure that the at least one battery 3 will not be displaced due to shaking or impact, the housing body 1 includes a plurality of retaining walls 13 parallel to the side plates 12 (as shown in FIG. 3 and FIG. 9). Specifically, the retaining walls 13 are arranged in a C-shape and jointly have an opening corresponding in position to the mounting hole A13. The at least one battery 3 can enter the accommodation space A11 by passing through the mounting hole A13, and the retaining walls 13 are configured to abut against the at least one battery 3.

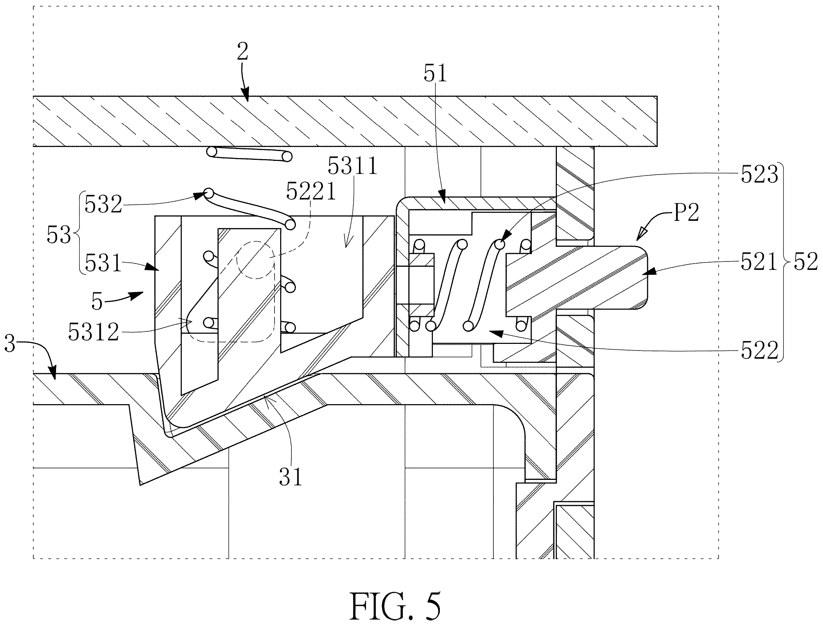

It is worth noting that, in order to facilitate the quick release of the at least one battery 3, the battery induction warmer 100 further includes a limiting structure 5, and the at least one battery 3 has a recessed groove 31 that can cooperate with the limiting structure 5 (as shown in FIG. 5, FIG. 7, and FIG. 8).

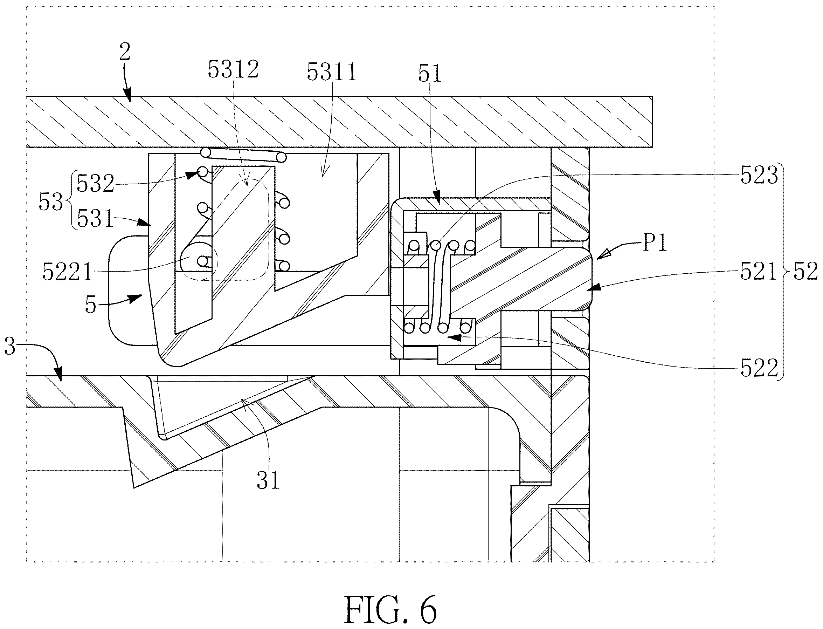

Specifically, a portion of the limiting structure 5 is exposed from the outer side of the housing body 1, and the portion of the limiting structure 5 is capable of being operated (e.g., by a press action), such that the limiting structure 5 is movable between a release position P1 (as shown in FIG. 6) and a restriction position P2 (as shown in FIG. 5).

When the limiting structure 5 is located in the restriction position P2 (as shown in FIG. 5), the limiting structure 5 abuts against the recessed groove 31 of the at least one battery 3 and restricts the at least one battery 3 from movement. When the limiting structure 5 is located in the release position P1 (as shown in FIG. 6), the limiting structure 5 is moved away from the recessed groove 31 of the at least one battery 3, and the at least one battery 3 is configured to detachable from the housing body 1.

Referring to FIG. 5, FIG. 7, and FIG. 8, the limiting structure 5 in one embodiment may include an installation bracket 51, an operating element 52, and a hook element 53. In detail, the installation bracket 51 is fixed on the housing body 1 and located in the accommodation space A11. The operating element 52 is disposed on the installation bracket 51, and the operating element 52 includes a button 521, two drive arms 522, and a first spring 523.

The button 521 is located on one of two sides of the installation bracket 51, and the two drive arms are connected to the button 521. A portion of each of the two drive arms 522 spans across the installation bracket 51 and is located on another one of the two sides of the installation bracket 51. Moreover, the portion of each of the two drive arms 522 has a bump 5221.

The first spring 523 is disposed between a surface of the installation bracket 51 and a surface of the button 521 that face each other. That is to say, the first spring 523 is configured to abut against the button 521 and the installation bracket 51, such that the button 521 and the two drive arms 522 jointly move in a direction away from a center of the housing body 1.

Furthermore, the hook element 53 is located on the another one of the two sides of the installation bracket 51, and the hook element 53 includes a hook block 531 and a second spring 532.

The hook block 531 has an accommodating groove 5311 and two tracks 5312. Each of the two tracks 5312 is in spatial communication with the accommodating groove 5311 and is skewed relative to a longitudinal direction of the first spring 523. In the present embodiment, the two tracks 5312 are triangles, and a side edge of each of the triangles is skewed relative to the longitudinal direction of the first spring 523, but the present invention is not limited thereto.

Two bumps 5221 of the two drive arms 522 are respectively assembled in the two tracks 5312, such that the hook block 531 is movable relative to the operating element 52. More specifically, the hook block 531 can move up and down according to the position that the limiting structure 5 is in (i.e., the release position P1 and the restriction position P2).

The second spring 532 is disposed in the accommodating groove 5311 and is perpendicular to the longitudinal direction of the first spring 523. The second spring 532 is configured to abut against the hook block 531 and the surface of the heating module 2.

Accordingly, the limiting structure 5 is configured to remain at the restriction position P2 by the first spring 523 and the second spring 532. When the limiting structure 5 is located in the restriction position P2, a portion of the button 521 is exposed from the outer side of the housing body 1, and the hook block 531 is pulled by the two drive arms 522, such that the hook block 531 abuts against the recessed groove 31. When the limiting structure 5 is located in the release position P1, the portion of the button 521 moves towards the housing body 1, and the hook block 531 is pushed by the two drive arms 522, such that the hook block 531 is detached from the recessed groove 31.

Moreover, in order to facilitate the at least one battery 3 to quickly connect to the control module 4, the at least one battery 3 includes an output port 32, and the control module 4 includes an input port 41 (as shown in FIG. 4 and FIG. 9). Specifically, the input port 41 is disposed in a position that corresponds in position to the at least one battery 3 located in the accommodation space A11. Therefore, when the at least one battery 3 is restricted from movement by the limiting structure 5 located in the restriction position P2, the output port 32 is electrically coupled to the input port 41, such that power from the at least one battery 3 is input to the control module 4. When the at least one battery 3 detached from the housing body 1, the output port 32 is away from the input port 41 and is not electrically coupled to the input port 41.

Referring to FIG. 9, the control module 4 is disposed in the accommodation space A11 and is electrically coupled to the heating module 2 and the at least one battery 3. The control module 4 is configured to control the heating module 2 to perform heating via power from the at least one battery 3.

It should be noted that, the control module 4 will generate high temperature during operation, so the battery induction warmer 100 can further include a plurality of cooling fins 6 that are in contact with the control module 4, and the housing body 1 further has two vent regions 14 that are in spatial communication with the accommodation space A11. Accordingly, the cooling fins 6 can absorb a heat energy from the control module 4 and discharge the heat energy through the two vent regions 14.

Moreover, when the cooling fins 6 absorb the heat energy, an airflow can be generated in the housing body 1, and the airflow can help dissipate heat from the at least one battery 3. Preferably, a height of each of the retaining walls 13 is less than a height of the at least one battery 3, such that the retaining walls 13 and the heating module 2 jointly have a heat dissipation gap HG there-between (as shown in FIG. 3).

Specifically, one of the two vent regions 14 is disposed on the one of the side plates 12 away from the at least one battery 3, and the at least one battery 3, the cooling fins 6, the heat dissipation gap HG, and the one of the two vent regions 14 are jointly passed by an imaginary configuration line LCL (as shown in FIG. 9), such that the airflow has a shortest exit path. Moreover, a length of a projection region defined by orthogonally projecting the cooling fins 6 onto the one of the two vent regions 14 along the imaginary configuration line LCL and a length of a projection region defined by orthogonally projecting the cooling fins 6 onto the at least one battery 3 along the imaginary configuration line LCL are greater than 50% of a length of the cooling fins 6.

Naturally, the battery induction warmer 100 can further include a fan 7 disposed in the accommodation space A11, and the fan 7 can enhance the cooling effect. In detail, the cooling fins 6 are arranged to be parallel to each other and perpendicular to the imaginary configuration line. The fan 7 has an airflow path, and the airflow path is configured to pass through the cooling fins 6 and exit from another one of the two vent regions 14 disposed on the bottom plate 11 by the side plates 12. In other words, the airflow hits the side plates 12, causing the airflow to turn and pass through the another one of the two vent regions 14.

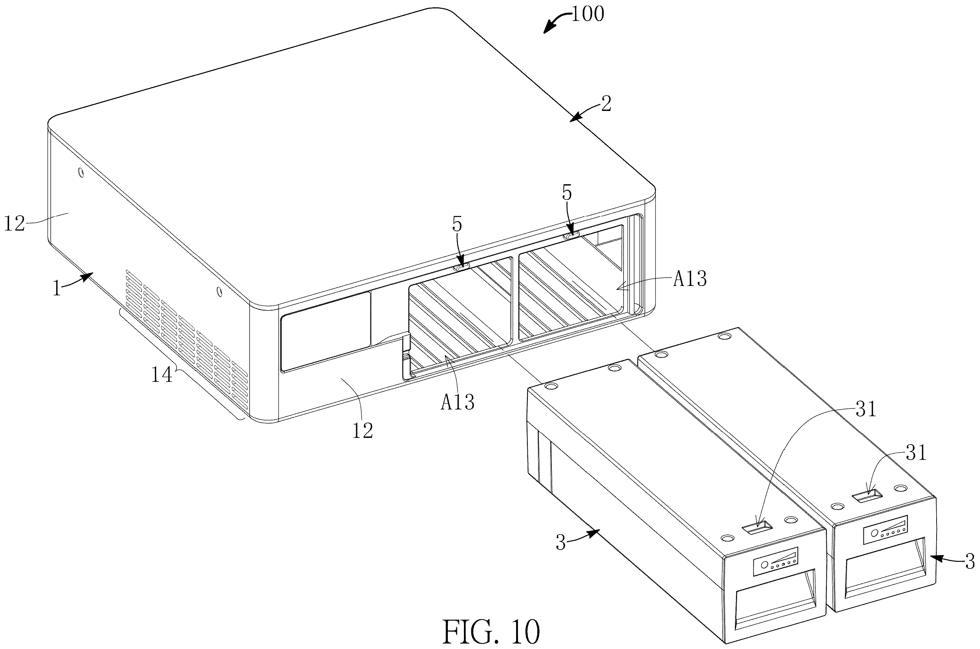

It is worth noting that, a quantity of the at least one battery 3 can be 2 (as shown in FIG. 10), and the two batteries 3 can be alternately used (e.g., one of the two batteries 3 is charged, and another one of the two batteries 3 supplies power to the heating module 2). Therefore, the control module 4 can be configured to detect charge levels of the two batteries 3 and select one of the two batteries 3 having a higher charge level to power the heating module 2.

### [Beneficial Effects of the Embodiment]

In conclusion, in the battery induction warmer provided by the present invention, by virtue of "the at least one battery being detachably disposed in the housing body by passing through the mounting hole," and "the control module being configured to control the heating module to perform heating via power from the at least one battery," the battery induction warmer can be used in any area and can quickly maintain the operation of the battery induction warmer by replacing the at least one battery.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A battery induction warmer (100), **characterized by** comprising:
a housing body (1) having an accommodation space (A11), and a top opening (A12) and a mounting hole (A13) that are in spatial communication with the accommodation space (A11);
a heating module (2) disposed on the housing body (1), wherein the top opening (A12) is covered by the heating module (2), and a portion of the heating module (2) is located in the accommodation space (A11);
at least one battery (3) detachably disposed in the housing body (1) by passing through the mounting hole (A13), wherein the at least one battery (3) is located in the accommodation space (A11), and a portion of the at least one battery (3) is exposed from an outer side of the housing body (1) by the mounting hole (A13); and
a control module (4) disposed in the accommodation space (A11) and electrically coupled to the heating module (2) and the at least one battery (3), wherein the control module (4) is configured to control the heating module (2) to perform heating via power from the at least one battery (3).

2. The battery induction warmer (100) according to claim 1, wherein the housing body (1) has a bottom plate (11) that is opposite to the top opening (A12), and a plurality of side plates (12) that are connected to the bottom plate, and wherein the mounting hole (A13) is located on one of the side plates (12).

3. The battery induction warmer (100) according to claim 2, wherein a surface of the portion of the at least one battery (3) exposed from the outer side of the housing body (1) and the one of the side plates (12) having the mounting hole (A13) are coplanar.

4. The battery induction warmer (100) according to claim 2, wherein the housing body (1) further includes a plurality of retaining walls (13) parallel to the side plates (12), and the retaining walls (13) are configured to abut against the at least one battery (3); wherein a height of each of the retaining walls (13) is less than a height of the at least one battery (3), so that the retaining walls (13) and the heating module (2) jointly have a heat dissipation gap (HG) there-between.

5. The battery induction warmer (100) according to claim 4, further comprising a plurality of cooling fins (6) disposed in the accommodation space (A11); wherein the housing body (1) has two vent regions (14) that are in spatial communication with the accommodation space (A11), and one of the two vent regions (14) is disposed on one of the side plates (12) away from the at least one battery (3); wherein the at least one battery (3), the cooling fins (6), the heat dissipation gap (HG), and the one of the two vent regions (14) are jointly passed by an imaginary configuration line.

6. The battery induction warmer (100) according to claim 4, further comprising a fan (7) disposed in the accommodation space (A11); wherein the cooling fins (6) are parallel to each other and perpendicular to the imaginary configuration line; wherein the fan (7) has an airflow path, and the airflow path is configured to pass through the cooling fins (6) and exit from another one of the two vent regions (14) disposed on the bottom plate (11) by the side plates (12).

7. The battery induction warmer (100) according to claim 1, further comprising a limiting structure (5) disposed on the housing body (1); wherein the at least one battery (3) has a recessed groove (31); wherein a portion of the limiting structure (5) is exposed from the outer side of the housing body (1), and the portion of the limiting structure (5) is capable of being operated, so that the limiting structure (5) is movable between a release position (P1) and a restriction position (P2); wherein, when the limiting structure (5) is located in the restriction position (P2), the limiting structure (5) abuts against the recessed groove (31) of the at least one battery (3) and restricts the at least one battery (3) from movement; and wherein, when the limiting structure (5) is located in the release position (P1), the limiting structure (5) is moved away from the recessed groove (31) of the at least one battery (3), and the at least one battery (3) is detachable from the housing body (1).

8. The battery induction warmer (100) according to claim 7, wherein the at least one battery (3) includes a output port (32), and the control module (4) includes an input port (41); wherein, when the at least one battery (3) is restricted from movement by the limiting structure (5) located in the restriction position (P2), the output port (32) is electrically coupled to the input port (41), so that power from the at least one battery (3) is input to the control module (4); wherein, when the at least one battery (3) is detached from the housing body (1), the output port (32) is away from the input port (41) and is not electrically coupled to the input port (41).

9. The battery induction warmer (100) according to claim 7, wherein the limiting structure (5) includes:
an installation bracket (51) fixed on the housing body (1) and located in the accommodation space (A11);
an operating element (52) disposed on the installation bracket (51), wherein the operating element (52) includes:
a button (521) located on one of two sides of the installation bracket (51);
two drive arms (522) connected to the button (521), wherein a portion of each of the two drive arms (522) spans across the installation bracket (51) and is located on another one of the two sides of the installation bracket (51), wherein the portion of each of the two drive arms (522) has a bump (5221); and
a first spring (523) disposed between a surface of the installation bracket (51) and a surface of the button (521) that face each other, wherein the first spring (523) is configured to abut against the button (521) and the installation bracket (51), so that the button (521) and the two drive arms (522) move in a direction away from a center of the housing body (1); and
a hook element (53) located on the another one of the two sides of the installation bracket (51), wherein the hook element (53) includes:
a hook block (531) having an accommodating groove (5311) and two tracks (5312), wherein each of the two tracks (5312) is in spatial communication with the accommodating groove (5311) and is skewed relative to the longitudinal direction of the first spring (523); wherein the two bumps (5221) of the two drive arms (522) are respectively assembled in the two tracks (5312), so that the hook block (531) is movable relative to the operating element (52); and
a second spring (532) disposed in the accommodating groove (5311) and perpendicular to the longitudinal direction of the first spring (523), wherein the second spring (532) is configured to abut against the hook block (531) and the surface of the heating module (2);
wherein the limiting structure (5) is configured to remain at the restriction position (P2) by the first spring (523) and the second spring (532); wherein, when the limiting structure (5) is located in the restriction position (P2), a portion of the button (521) is exposed from the outer side of the housing body (1), and the hook block (531) is pulled by the two drive arms (522), so that the hook block (531) abuts against the recessed groove (31); wherein, when the limiting structure (5) is located in the release position (P1), the portion of the button (521) moves towards the housing body (1), and the hook block (531) is pushed by the two drive arms (522), so that the hook block (531) detached the recessed groove (31).

10. The battery induction warmer (100) according to claim 1, wherein a quantity of the at least one battery (3) is 2, and the control module (4) is configured to detect charge levels of the two batteries and select one of the two batteries having a higher charge level to power the heating module (2).
